# DEMANDE DE BREVET EUROPEEN

(11) **EP 4 450 399 A1**
(43) Date de publication de la demande: **23.10.2024**
(21) Numéro de dépôt: 24154509.4
(22) Date de dépôt: 29.01.2024
(51) Int. Cl.: B64D 31/06, B64C 27/04, G09B 9/18, G09B 9/44, G09B 9/46

(54) **PROCEDE ET GIRAVION MULTIMOTEUR POUR SIMULER LA PANNE D'UN MOTEUR**

(30) Priorité: 19.04.2023 FR 2303889
(71) Demandeur: Airbus Helicopters, 13725 Marignane Cedex (FR)
(72) Inventeur: DUMUR, Guillaume, 13300 SALON DE PROVENCE (FR); FRAENZEL, Julien, 13790 PEYNIER (FR)
(74) Mandataire: GPI Brevets

(57) **Abrégé**

La présente invention concerne un procédé de simulation d'une panne moteur sur un giravion (1) comprenant plusieurs moteurs (10) pour mettre en mouvement une voilure tournante (6). Le procédé comprenant un mode école comportant une régulation avec un régulateur (30) de chaque moteur (10) pour simuler une panne moteur, cette régulation comprenant une limitation de la puissance de chaque moteur (10) à une butée de régulation respective. Le mode école comporte les étapes suivantes : i) détermination avec le régulateur (30) d'une part d'une masse maximale en fonction au moins de conditions extérieures et d'autre part d'une masse initiale du giravion (1) au moins en fonction d'une masse à vide du giravion (1), d'une masse d'un équipage présent dans le giravion(1), d'une masse de carburant embarqué estimée, ii)comparaison avec le régulateur (30) de la masse initiale à la masse maximale, iii) détermination avec le régulateur (30) de chaque butée de régulation en fonction de ladite comparaison.

## Description

La présente invention concerne un procédé et un giravion multimoteur pour simuler la panne d'un moteur.

Un giravion multimoteur comprend une voilure tournante mise en mouvement par une installation motrice ayant au moins deux moteurs.

Ainsi, chaque moteur peut fonctionner selon une pluralité de régimes usuels dans des conditions normales, à savoir hors cas de panne ou de simulation. Ces régimes usuels de fonctionnement dans des conditions normales peuvent comprendre un régime continu durant lequel le moteur peut fournir une puissance maximale continue PMC, et un régime de fonctionnement au décollage durant lequel le moteur peut fournir une puissance maximale au décollage PMD supérieure à la puissance maximale continue PMC.

Les moteurs sont en outre dimensionnés afin que l'installation motrice développe une puissance motrice suffisante pour assurer le vol en cas de panne totale d'un moteur. Ainsi, chaque moteur peut fonctionner selon une pluralité de régimes d'urgence en cas de panne d'un autre moteur. Ces régimes d'urgence sont parfois dénommés OEI, cet acronyme correspondant à l'expression anglaise « one engine inoperative ». Ces régimes d'urgence peuvent comprendre :
- un premier régime d'urgence limité à une puissance de super urgence dénommée OEI30", utilisable pendant une durée de l'ordre de trente secondes consécutives, ce premier régime d'urgence pouvant être utilisé environ trois fois pendant un vol,
- un deuxième régime d'urgence limité à une puissance maximale d'urgence dénommée OEI2', utilisable pendant une durée de l'ordre de deux minutes, et
- un troisième régime d'urgence limité à une puissance intermédiaire d'urgence dénommée OEIcontinu, utilisable pendant une durée couvrant par exemple la fin du vol.

Les puissances maximales associées à chaque régime sont définies notamment en fonction des conditions extérieures.

Afin d'entraîner les pilotes des aéronefs à la panne totale d'un moteur et au fonctionnement dégradé associé, un giravion peut disposer d'un mode dit « école ».

Lors du mode école, l'installation motrice développe globalement avec les moteurs une « puissance globale réduite », plafonnée à la puissance d'un régime d'urgence. Les moteurs peuvent développer à cet effet des puissances équivalentes ou différentes.

Selon un autre aspect, les performances d'un giravion dépendent de fait de la masse de ce giravion. Or, la puissance développée par une installation motrice varie en fonction de l'altitude de l'aéronef, notamment en présence de turbomoteurs. Un constructeur peut ainsi établir la masse maximale autorisée du giravion en fonction de l'altitude envisagée pour le vol.

Dès lors, si le mode école est activé avec un giravion présentant une masse très inférieure à sa masse maximale, la puissance requise par le giravion peut être inférieure à la puissance maximale du régime d'urgence testé. Cet entraînement n'est dès lors pas optimal.

Or, un tel vol d'entraînement est souvent réalisé avec un hélicoptère relativement léger comprenant seulement l'élève pilote et son instructeur. Pour optimiser l'entraînement, l'instructeur et l'élève peuvent lester le giravion. Cette solution permet effectivement de rapprocher la masse du giravion de sa masse maximale autorisée mais s'avère néanmoins contraignante.

Des giravions peuvent être munis de systèmes divers pour réaliser un vol d'entrainement à la panne d'un moteur sur un giravion.

Dans ce contexte, le document US 5873546 A divulgue des modules et des procédés pour pondérer la puissance d'une installation motrice multimoteur d'hélicoptère. Une masse d'entrainement est évaluée notamment en fonction des conditions climatiques ambiantes telles la température et l'altitude.

Le document EP 2254793 décrit un giravion muni d'une interface munie de deux commutateurs, pour respectivement simuler un aéronef présentant une charge embarquée maximale, et un aéronef présentant une charge embarquée maximale et portant une charge maximale avec un crochet.

Le document EP2624239 décrit quant à lui un giravion muni d'un moyen de réglage qui peut être utilisé par un instructeur pour adapter la puissance globale réduite et simuler différentes configurations de panne.

Le document US 2009/186320 A1 est aussi connu.

Le document « Getting to grips with aircraft performance », 1 janvier 2002 (2002-01-01), pages 1-216, XP093085967, extrait de l'internet à l'url : https://skybrary.aero/sites/default/files/bookshelf/2263.pdf (extrait le 2023-09-26) est aussi connu.

Le document « How much does a helicopter weigh ? », 26 octobrer 2022 (2022-10-26), XP093085983, extrait de l'internet à l'url : https://www.aeroclass.org/How-much-does-a-helicopter-weigh/ (extrait le 2023-09-26) est aussi connu.

La présente invention a alors pour objet de proposer un procédé innovant pour simuler la panne d'un moteur sur un giravion multimoteur.

L'invention vise ainsi un procédé de simulation d'une panne moteur sur un giravion, le giravion comprenant une installation motrice munie de plusieurs moteurs développant conjointement une puissance globale pour mettre en mouvement une voilure tournante, au moins un moteur fonctionnant en brûlant du carburant, chaque moteur présentant un paramètre de régulation plafonné par un régulateur à une valeur de régulation limite durant au moins un régime d'urgence applicable en cas de panne d'un autre moteur, le procédé comprenant un mode école comportant une régulation avec le régulateur de chaque moteur afin de simuler une panne moteur, ladite régulation avec le régulateur de chaque moteur comprenant un plafonnement du paramètre de régulation de chaque moteur à une butée de régulation respective.

Le mode école comporte les étapes suivantes :
- détermination, éventuellement en vol à une initialisation du mode école, avec le régulateur d'une masse initiale dudit giravion au moins en fonction d'une masse à vide du giravion, d'une masse d'un équipage présent dans le giravion paramétrée, d'une masse de carburant embarqué estimée,
- détermination en vol, voire à une initialisation du mode école, d'une masse maximale pour le giravion établie en fonction au moins de conditions extérieures,
- comparaison en vol avec le régulateur de la masse initiale à la masse maximale,
- détermination avec le régulateur de chaque butée de régulation en fonction de ladite comparaison et de ladite valeur de régulation limite.

Le paramètre de régulation peut être un couple moteur ou une puissance par exemple.

La masse maximale est établie par le régulateur en fonction notamment de conditions extérieures, par exemple à l'aide d'un modèle de masse mémorisé. Par exemple, le régulateur comporte un tableur ou une loi mathématique fournissant la masse maximale en fonction des conditions extérieures.

Ce procédé est ainsi relatif à l'application d'un mode école, par exemple suite à une activation de ce mode école avec une interface homme-machine de commande.

Ainsi, le régulateur est configuré pour déterminer une masse initiale du giravion, à savoir sensiblement proche de la masse réelle du giravion à l'initialisation du mode école. Ce régulateur compare la masse initiale à la masse maximale puis régule les moteurs pour que le rapport poids/puissance du giravion lors de l'application du mode école soit sensiblement équivalent au rapport poids/puissance qu'aurait le giravion en présentant sa masse maximale et un moteur en panne lors de l'application du régime d'urgence en cours. Autrement dit, plus le giravion est léger, plus les butées de régulation du ou des régimes d'urgence baissent.

A cet effet, le régulateur adapte la valeur de chaque butée de régulation. Par exemple, le régulateur applique un modèle mathématique, établi par essais et/ou simulations éventuellement, pour établir les butées de régulation en fonction de la comparaison de la masse initiale à la masse maximale.

A titre d'exemple, sur un giravion bimoteur, un moteur peut être dimensionné pour développer un couple de 600 Newton-mètres dans le régime d'urgence courant avec les conditions extérieures actuelles, l'autre moteur ne développant aucune puissance en raison de sa panne. Pour simuler cette situation sur un giravion usuel, les deux moteurs sont pilotés pour, par exemple, développer chacun un couple moteur de 300 Newton-mètres. Selon l'invention, si le giravion présente une masse initiale de l'ordre de 80 pourcents de la masse maximale alors le régulateur peut réguler chaque moteur pour plafonner le couple moteur à 240 Newton-mètres, soit 80 pourcents des 300 Newton-mètres précités.

Dès lors, le procédé de l'invention permet d'adapter les butées de régulation des moteurs durant le mode école en fonction de la masse initiale du giravion pour simuler une panne moteur se produisant sur un giravion présentant sa masse maximale avec les conditions extérieures actuelles. Ainsi, l'entraînement est optimisé en plaçant le giravion dans des conditions proches des conditions les plus défavorables, à savoir une panne moteur au sein d'un giravion présentant sa masse maximale.

Le procédé selon l'invention peut de plus comporter une ou plusieurs des caractéristiques qui suivent.

Ainsi, les conditions extérieures peuvent comporter une pression extérieure et une température extérieure de l'air présent autour du giravion, ladite initialisation du mode école comportant une estimation de la pression extérieure avec un senseur de pression extérieure du régulateur et de la température extérieure avec un senseur de température extérieure du régulateur.

Cette caractéristique permet de prendre en considération l'impact des conditions extérieures sur le fonctionnement des moteurs.

Indépendamment de cette caractéristique et selon une première alternative de l'invention, le procédé peut comporter une mesure d'une quantité courante de carburant dans le giravion avec un jaugeur du régulateur, puis une estimation de ladite masse de carburant en fonction de la quantité courante à une initialisation du mode école.

La quantité courante peut être une masse courante ou un volume courant de carburant.

Selon cette première alternative, si la quantité courante est une masse courante de carburant alors la masse de carburant est égale à la quantité courante.

Par contre, si la quantité courante est un volume courant de carburant alors la masse du carburant peut correspondre au produit du volume courant du carburant présent dans le giravion à l'initialisation du mode école et de la masse volumique du carburant. Cette masse volumique peut être mémorisée dans le régulateur. Eventuellement, le régulateur peut comprendre une liste de carburant et une interface permettant à un équipage de sélectionner le carburant embarqué.

Cette première alternative permet d'estimer précisément la masse initiale à une initialisation du mode école, à savoir suite à l'activation de ce mode école.

Selon une deuxième alternative, ledit mode école peut comporter un paramétrage d'une quantité avant vol de carburant avec une interface homme-machine de paramétrage de carburant du régulateur, le procédé comportant : i) une estimation d'une quantité de carburant consommée jusqu'à une initialisation du mode école, et ii) une estimation de ladite masse de carburant en fonction de la quantité avant vol de carburant ainsi que de la quantité de carburant consommé, voire d'une masse volumique du carburant.

Selon la deuxième alternative, un équipage paramètre manuellement la quantité avant vol de carburant embarqué, à savoir la masse ou le volume de carburant embarqué. Le régulateur est alors configuré pour calculer la quantité de carburant consommée à l'aide d'au moins un débitmètre par exemple, le produit d'un débit et d'une durée permettant d'en déduire un volume. Le régulateur est aussi configuré pour en déduire la masse de carburant au moment de l'initialisation du mode école, en prenant en considération la masse volumique du carburant si une desdites quantités est un volume de carburant. Par exemple, la quantité avant vol et la quantité de carburant consommée sont des volumes de carburant, la masse de carburant étant alors égale au produit de la masse volumique et de la différence arithmétique de la quantité avant vol moins la quantité de carburant consommée.

Cette deuxième alternative permet d'estimer précisément la masse initiale.

Selon la deuxième alternative, le procédé peut donc comporter un paramétrage avant un démarrage des moteurs de la quantité avant vol avec une interface homme-machine de paramétrage de carburant du régulateur, la quantité avant vol étant figée après ledit démarrage.

Selon une troisième alternative, la masse de carburant peut être paramétrée avec une interface homme-machine de paramétrage de carburant du régulateur.

Un équipage peut paramétrer manuellement la masse de carburant, par exemple à une initialisation du mode école, pour tester une configuration particulière éventuellement pour adapter l'essai au niveau d'un élève.

Eventuellement, le procédé peut comporter un paramétrage avant un démarrage des moteurs de la masse de carburant, la masse de carburant étant figée après ledit démarrage.

Un même giravion peut éventuellement être configuré pour pouvoir mettre en oeuvre plusieurs alternatives. Par exemple, le giravion peut comprendre une interface homme-machine de choix pour choisir l'alternative souhaitée, par exemple en fonction du but pédagogique de l'entraînement au pilotage en mode OEI.

Quelle que soit l'alternative, le procédé peut comporter une sélection d'un type d'entraînement avec une interface homme-machine de sélection du régulateur, la détermination en vol avec le régulateur de la masse maximale étant fonction du type d'entraînement sélectionné avec l'interface homme-machine de sélection.

La puissance à fournir par les moteurs varie en fonction du type d'entraînement. Le procédé peut donc le prendre en considération.

Eventuellement, ledit type d'entraînement peut être choisi dans une liste comprenant : un entraînement de catégorie A requérant la possibilité de poursuivre le vol et un entraînement de catégorie B requérant la possibilité d'atterrir en sécurité.

Selon une possibilité compatible avec les précédentes, ladite comparaison avec le régulateur de la masse initiale à la masse maximale peut comporter un établissement d'un rapport de proportion entre la masse initiale et la masse maximale.

Le rapport peut être par défaut égal à 1 par sécurité.

Dès lors, selon une première variante, ladite détermination avec le régulateur de chaque butée de régulation en fonction de ladite comparaison peut comprendre pour chaque moteur : i) une estimation d'une valeur de régulation de calcul en fonction dudit rapport de proportion et de la valeur de régulation limite, puis ii) une détermination de la butée de régulation en fonction de ladite valeur de régulation de calcul et d'un coefficient de répartition propre à chaque butée de régulation.

La valeur de régulation de calcul peut être égale au produit du rapport de proportion et de la valeur de régulation limite. Une butée de régulation peut être égale au produit de la valeur de régulation de calcul et du coefficient de répartition associé.

Dans ce cas, le régulateur estime les valeurs de régulation limite de manière usuelle, puis en déduit les butées de régulation. Par exemple, le coefficient de répartition peut être égal au nombre de moteurs en fonctionnement.

Alternativement, ladite détermination avec le régulateur de chaque butée de régulation en fonction de ladite comparaison peut comprendre pour chaque moteur i) une estimation d'une valeur intermédiaire en fonction d'un coefficient de répartition propre à chaque butée de régulation et de la valeur de régulation limite, puis ii) une détermination de chaque butée de régulation en fonction de ladite valeur intermédiaire et dudit rapport de proportion.

La valeur intermédiaire peut être égale au produit du coefficient de répartition associé et de la valeur de régulation limite. Une butée de régulation peut être égale au produit de la valeur intermédiaire et du rapport de proportion.

Cette alternative peut être aisément implémentée au sein d'un aéronef comprenant des calculateurs moteurs qui plafonnent un paramètre de régulation à la valeur intermédiaire pour chaque moteur durant le mode école. En effet, les calculateurs moteurs peuvent être modifiés pour recevoir le rapport de proportion et l'appliquer à la valeur intermédiaire déterminée de manière usuelle.

Selon une possibilité compatible avec les précédentes, le procédé peut comporter un paramétrage avant un démarrage des moteurs de la masse à vide avec une interface homme-machine de masse à vide du régulateur, et un paramétrage avant un démarrage des moteurs de la masse d'un équipage présent dans le giravion avec une interface homme-machine de masse équipage du régulateur, la masse à vide et la masse d'un équipage présent dans le giravion étant figées après ledit démarrage.

Selon un exemple, la masse à vide peut être égale à une somme d'une masse nue du giravion, paramétrée avec l'interface homme-machine de masse à vide ou mémorisée, d'une masse d'équipements optionnels paramétrée avec l'interface homme-machine de masse à vide, et d'une masse de fret paramétrée avec l'interface homme-machine de masse à vide.

Selon un autre exemple, la masse à vide peut être égale à une somme d'une masse nue de l'aéronef vide, paramétrée avec l'interface homme-machine de masse à vide ou mémorisée voire incluant des équipements optionnels installés, et d'une masse de fret paramétrée avec l'interface homme-machine de masse à vide.

Selon un exemple, la masse à vide peut être égale à la masse paramétrée avec l'interface homme-machine de masse à vide.

Selon une possibilité compatible avec les précédentes, le procédé peut comporter une mesure d'une vitesse de rotation de la voilure tournante avec un senseur de vitesse de rotation du régulateur, un désengagement automatique avec le régulateur du mode école dès que la vitesse de rotation est inférieure à un seuil mémorisé, et une génération d'une alerte porteuse du désengagement.

Le mode école peut être automatiquement désactivé si la puissance globale développée est insuffisante pour permettre d'entrainer la voilure tournante à une vitesse de rotation minimale. L'équipage en est informé.

L'invention vise aussi un giravion comprenant une installation motrice munie de plusieurs moteurs développant conjointement une puissance globale pour mettre en mouvement une voilure tournante, chaque moteur développant une puissance plafonnée par un régulateur à une valeur de puissance limite lors de l'application d'au moins un régime d'urgence en cas de panne d'au moins un autre moteur.

Le régulateur est ainsi configuré pour appliquer le procédé de l'invention.

A cet effet, le régulateur peut comprendre par exemple un doseur de carburant par moteur commandé par un contrôleur. Le contrôleur peut être en communication avec au moins un des organes suivants : un senseur de pression extérieure, un senseur de température extérieure, un senseur de vitesse de rotation mesurant la vitesse de rotation de la voilure tournante, au moins un senseur de régulation d'un moteur, une interface homme-machine de masse à vide, une interface homme-machine de masse équipage, une interface homme-machine de sélection, une interface homme-machine de choix, une interface homme-machine de paramétrage de carburant.

L'invention et ses avantages apparaîtront avec plus de détails dans le cadre de la description qui suit avec des exemples donnés à titre illustratif en référence aux figures annexées qui représentent :
la figure 1, une vue d'un giravion selon l'invention,
la figure 2, un logigramme présentant le procédé selon l'invention,
la figure 3, un logigramme présentant une méthode d'estimation de la masse de carburant,
la figure 4, un logigramme présentant une méthode d'estimation de la masse de carburant, et
la figure 5, un logigramme présentant une méthode d'estimation de la masse de carburant.

Les éléments présents dans plusieurs figures distinctes sont affectés d'une seule et même référence.

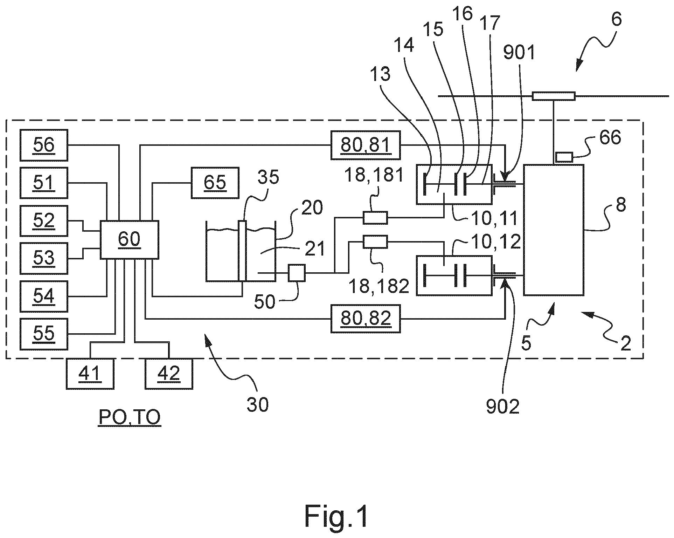

La figure 1 présente un exemple de giravion 1 selon l'invention. Ce giravion 1 comporte une voilure tournante 6.

Le giravion 1 comporte de plus une installation motrice 2 pour mettre en rotation la voilure tournante 6, par exemple afin d'assurer la sustentation, voire l'avancement, de ce giravion 1. Cette installation motrice 2 est pourvue d'au moins deux moteurs 10. La référence 10 désigne n'importe quel moteur, les références 11, 12 désignant des moteurs particuliers si besoin pour identifier un moteur 10 spécifique.

Au moins un voire chaque moteur 10 est alimenté en carburant 21 par au moins un réservoir 20 via un circuit de carburant.

Selon un exemple, au moins un moteur 10 peut être un turbomoteur. Un tel turbomoteur 10 comporte un générateur de gaz qui est muni d'au moins une turbine de compression 13, d'une chambre de combustion 14 dans laquelle est injecté le carburant 21 et d'au moins une turbine de détente 15 liée en rotation à la ou aux turbines de compression 13. De plus, le turbomoteur 10 peut comporter au moins une turbine libre 16 qui met en mouvement directement ou indirectement un arbre de puissance 17 du moteur.

Indépendamment du type des moteurs, chaque moteur 10 peut comporter un arbre de puissance 17 connecté à une chaîne de transmission de puissance 5. La chaîne de transmission de puissance 5 est alors reliée de manière usuelle à la voilure tournante 6. A titre illustratif, la chaîne de transmission de puissance 5 peut être munie d'une boîte de transmission de puissance qui est mécaniquement interposée entre les moteurs 10 et la voilure tournante 6. La chaîne de transmission de puissance 5 peut comprendre au moins une roue libre, et/ou au moins un arbre de liaison, et/ou au moins un connecteur autorisant des désalignements...

Par ailleurs, les moteurs 10 sont des moteurs thermiques fonctionnant avec du carburant 21. Les moteurs 10 peuvent fonctionner selon une pluralité de régime, et notamment un des régimes précités à savoir le régime continu, le régime de fonctionnement au décollage, le première régime d'urgence, le deuxième régime d'urgence et le troisième régime d'urgence. Dès lors, le giravion 1 comporte un système de régulation dénommé plus simplement « régulateur 30 » pour piloter la puissance ou le couple délivré par chaque moteur 10 avec son arbre de puissance 17 en fonction notamment du régime courant appliqué.

Ainsi, le régulateur 30 peut comporter un doseur de carburant 18 par moteur 10, par exemple sur le circuit de carburant liant le ou les réservoirs 20 au moteur 10 associé. Chaque moteur 10 est alors relié via son propre doseur de carburant 18 à au moins un réservoir 20 de carburant. La référence 18 désigne n'importe quel doseur de carburant, les références 181, 182 désignant des doseurs de carburant particuliers respectivement des deux moteurs 11 ,12.

Par ailleurs, le régulateur 30 peut comprendre au moins un débitmètre 50 agencé sur le circuit de carburant pour évaluer la quantité de carburant consommée depuis le démarrage des moteurs 10.

Par ailleurs, le régulateur 30 peut comprendre un jaugeur 35 pour évaluer la quantité de carburant stockée dans le ou les réservoirs 20. Un tel jaugeur 35 peut comprendre, par exemple, une ou plusieurs cannes de jaugeage usuelles, cet exemple étant simplement donné pour illustrer le régulateur 30.

En outre, le régulateur 30 peut comporter un calculateur moteur 80 par moteur 10. Chaque calculateur moteur 80 peut comprendre, par exemple, au moins un processeur et au moins une mémoire, au moins un circuit intégré, au moins un système programmable, au moins un circuit logique, ces exemples ne limitant pas la portée donnée à l'expression « calculateur moteur ». Les calculateurs moteurs peuvent communiquer entre eux par des liaisons filaires ou non filaires.

Selon l'exemple décrit, l'installation motrice 2 comporte deux calculateurs moteur 81, 82 contrôlant respectivement les deux moteurs 11, 12. Chaque calculateur moteur 81, 82 est configuré pour piloter le moteur 11,12 associé et le faire fonctionner selon le régime requis, par exemple pour que le moteur 11,12 piloté présente un paramètre de régulation plafonné à une valeur de régulation limite de ce régime. Le paramètre de régulation peut être le couple moteur ou la puissance développée par le moteur par exemple.

La valeur de régulation limite est établie pour un giravion 1 de manière usuelle. Par exemple, chaque calculateur moteur détermine, en fonction du régime à appliquer, une première limite de couple à respecter pour ne pas endommager la chaîne de transmission de puissance 5 ainsi qu'une limite de température du moteur concernée convertie en une deuxième limite de couple et une limite de vitesse de rotation du générateur de gaz du moteur convertie en une troisième limite de couple et déterminée en fonction des conditions extérieures, la valeur de régulation limite étant égale à la plus petite de ces limites de couple.

Chaque calculateur moteur 81, 82 peut notamment contrôler le doseur de carburant 181, 182 du moteur 11, 12 associé. Chaque calculateur moteur 81,82 peut être relié à de multiples senseurs de régulation pour contrôler le moteur 11, 12 associé, tel que par exemple un couplemètre 901, 902 mesurant un couple moteur sur un organe tournant. Un tel organe tournant peut être un arbre de puissance 17 d'un moteur 10. Par exemple, le doseur de carburant 181, 182 est piloté via la mise en oeuvre d'une boucle de régulation visant à maintenir le couple développée par l'organe tournant inférieur ou égal à la valeur de régulation limite courante.

Le régulateur 30 peut en outre comprendre un contrôleur 60 en communication avec les calculateurs moteurs 80. Le contrôleur 60 peut comprendre par exemple au moins un processeur et au moins une mémoire, au moins un circuit intégré, au moins un système programmable, au moins un circuit logique, ces exemples ne limitant pas la portée donnée à l'expression « contrôleur ». Le contrôleur 60 peut communiquer par des liaisons filaires ou non filaires avec chaque calculateur moteur 80, voire peut être fusionné avec au moins un calculateur moteur 80.

Le contrôleur 60 peut communiquer par des liaisons filaires ou non filaires avec le cas échéant le jaugeur 35 et le débitmètre 50.

Indépendamment de sa composition, le contrôleur 60 peut communiquer par une liaison filaire ou non filaire avec au moins un alerteur 65 pour fournir des informations à un pilote. Un tel alerteur 65 peut, par exemple, comprendre un afficheur apte à afficher un message, une diode électroluminescente qui s'allume sur commande du contrôleur 60, un haut-parleur...

En outre, le contrôleur 60 peut communiquer avec une ou des interfaces homme-machine. Chaque interface homme machine peut comprendre au moins un organe manoeuvrable par un pilote, tel qu'un bouton ou un levier, un écran tactile, une commande vocale...

Dès lors, le contrôleur 60 peut communiquer avec une interface 51 homme-machine de paramétrage de carburant. Cette interface 51 homme-machine de paramétrage de carburant transmet un signal au contrôleur 60 porteur d'une quantité avant vol de carburant, à savoir d'une masse ou d'un volume avant vol de carburant.

Le terme signal désigne un signal numérique ou analogique, optique ou électrique.

Le contrôleur 60 peut communiquer avec une interface 52 homme-machine de sélection. Cette interface 52 homme-machine de sélection transmet un signal au contrôleur 60 porteur d'un type d'entraînement choisi. Par exemple, le type d'entraînement est choisi dans une liste comprenant un entraînement de catégorie A requérant la possibilité de poursuivre le vol après une panne moteur et un entraînement de catégorie B requérant la possibilité d'atterrir en sécurité après une panne moteur.

Le contrôleur 60 peut communiquer avec une interface 53 homme-machine de masse à vide. L'expression masse à vide désigne la masse du giravion 1 sans carburant et sans équipage. Cette interface 53 homme-machine de masse à vide transmet un signal, dit « signal de masse à vide » par commodité, au contrôleur 60 porteur d'une masse à vide du giravion 1. Cette masse à vide peut varier en fonction des équipements optionnels agencés sur le giravion 1, voire du lest embarqué. L'interface 53 homme-machine de masse à vide peut permettre de paramétrer tous les postes paramétrables influençant la masse à vide, tels que la masse nue du giravion, la masse de fret, la masse d'équipements.

Le contrôleur 60 peut communiquer avec une interface 54 homme-machine de masse équipage. Cette interface 54 homme-machine de masse équipage transmet un signal, dit « signal de masse équipage » par commodité, au contrôleur 60 porteur d'une masse de l'équipage, à savoir la masse de l'ensemble des occupants du giravion 1.

Le contrôleur 60 peut communiquer avec une interface 55 homme-machine d'activation du mode école. Cette interface 55 homme-machine d'activation du mode école transmet un signal au contrôleur 60 porteur d'une activation du mode école.

Le contrôleur 60 peut communiquer avec une interface 56 homme-machine de masse volumique. Cette interface 56 homme-machine de masse volumique transmet un signal, dit « signal de masse volumique » par commodité, au contrôleur 60 porteur d'une masse volumique du carburant embarqué. Ce signal peut soit comprendre la masse volumique en tant que telle, soit le type de carburant, le contrôleur mémorisant pour chaque type de carburant la masse volumique associée.

Par ailleurs, le contrôleur 60 peut être relié à un ou des senseurs, par des liaisons filaires ou non filaires par exemple.

Le contrôleur 60 peut être relié à un senseur de pression extérieure 41 transmettant un signal, dit « signal de pression » par commodité, porteur d'une pression extérieure P0 de l'air entournant le giravion 1.

De plus, le contrôleur 60 peut être relié à un senseur de température extérieure 42 transmettant un signal, dit « signal de température » par commodité, porteur d'une température extérieure T0 de l'air entourant le giravion 1.

Par ailleurs, le contrôleur 60 peut être relié à un senseur 66 de vitesse de rotation transmettant un signal, dit « signal de vitesse de rotation » par commodité, porteur d'une vitesse de rotation NR de la voilure tournante. Un tel senseur est connu de l'état de l'art.

Dans ce contexte, durant un mode de fonctionnement normal, chaque doseur de carburant 18 est piloté par le calculateur moteur 80 correspondant afin que l'installation motrice 2 développe une puissance globale WGLOB.

En cas de panne d'un des moteurs 10, chaque doseur de carburant 18 d'un moteur restant en fonctionnement est piloté par le calculateur moteur 80 correspondant afin que le moteur 10 développe avec son arbre de puissance 17 une puissance motrice d'urgence, un paramètre de régulation du moteur en fonctionnement étant plafonné à une valeur de régulation limite correspondant au régime d'urgence courant.

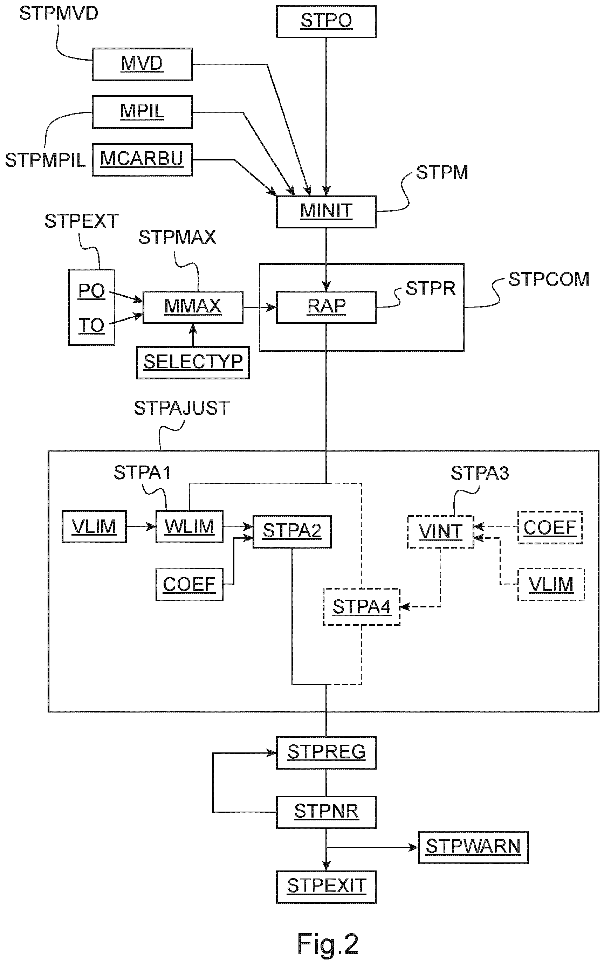

La figure 2 illustre alors des exemples de procédé de simulation d'une panne moteur pouvant être mis en oeuvre par le giravion de la figure 1.

A cet effet, le procédé peut comporter l'activation STP0 d'un mode école. Par exemple un instructeur ou un élève pilote sollicite l'interface 55 homme-machine d'activation du mode école. Cette interface 55 homme-machine d'activation du mode école transmet un signal au contrôleur 60 qui active le mode école.

Indépendamment de la manière de l'activer, le mode école comporte une détermination STPM avec le régulateur 30 d'une masse initiale MINIT du giravion 1 au moins en fonction de la masse à vide MVD paramétrée du giravion 1, de la masse MPIL de l'équipage paramétrée, d'une masse de carburant MCARBU embarqué. Eventuellement, le type d'entraînement est aussi pris en compte.

A cet effet, en prévision de cette simulation, le procédé peut comporter un paramétrage STPMVD avant un démarrage des moteurs 10 de la masse à vide MVD. Un équipage sollicite l'interface 53 homme-machine de masse à vide qui transmet un signal de masse à vide au contrôleur 60. Le contrôleur 60 décode le signal de masse à vide, puis en déduit et mémorise une valeur de masse à vide MVD.

Cette masse à vide MVD est éventuellement figée après le démarrage des moteurs, et ne peut alors plus être modifiée.

De même, le procédé peut comporter un paramétrage STPMPIL avant un démarrage des moteurs 10 de la masse MPIL d'un équipage. Un équipage sollicite l'interface 54 homme-machine de masse équipage qui transmet un signal de masse équipage au contrôleur 60. Le contrôleur 60 décode le signal de masse équipage puis en déduit et mémorise une valeur de masse équipage MPIL. Cette masse équipage MPIL est éventuellement figée après le démarrage des moteurs 10, et ne peut alors plus être modifiée.

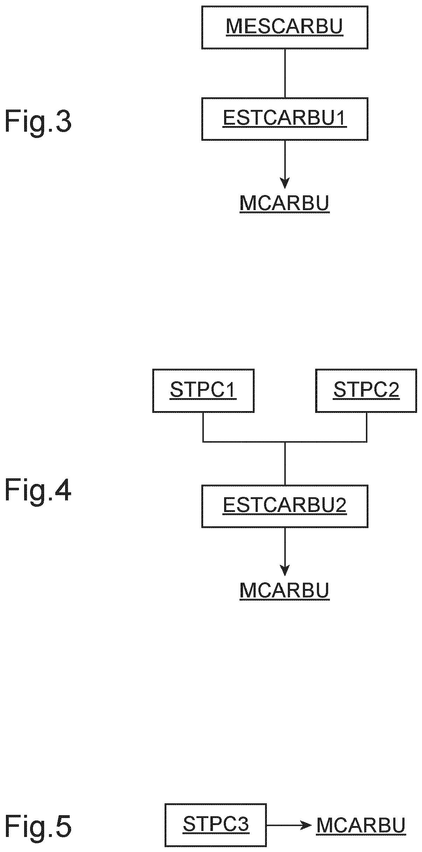

En outre, le régulateur 30 détermine la masse de carburant MCARBU. Les figures 3 à 5 illustrent trois alternatives possibles pour déterminer la masse de carburant MCARBU.

Selon la première alternative de la figure 3, le mode école comporte une mesure MESCARBU d'une quantité, et éventuellement d'un volume, de carburant dans le giravion 1 avec le jaugeur 35. Le jaugeur 53 transmet un signal dit « signal de carburant » par commodité, au contrôleur 60 porteur du volume ou de la masse de carburant contenu dans le ou les réservoirs 20. Le contrôleur 60 décode le signal de carburant et en déduit la masse de carburant MCARBU lors d'une étape d'estimation ESTCARBU1 de la masse de carburant. Par exemple, la masse de carburant MCARBU est alors égale au produit du volume de carburant mesuré par le jaugeur et de sa masse volumique. La masse volumique peut être mémorisée, ou encore paramétrée à l'aide d'une interface 56 homme-machine de masse volumique.

Selon la deuxième alternative de la figure 4, le mode école comporte un paramétrage STPC1 d'une masse ou d'un volume avant vol de carburant dit « quantité avant vol » avec l'interface 51 homme-machine de paramétrage de carburant. Ce paramétrage STPC1 peut être effectué avant un démarrage des moteurs 10, la masse avant vol ou le volume avant vol étant figé après ledit démarrage.

Cette interface 51 homme-machine de paramétrage de carburant transmet un signal au contrôleur 60. Le contrôleur 60 le décode et mémorise la masse avant vol ou le volume avant vol.

De plus, le mode école comporte une estimation STPC2 du volume de carburant consommé jusqu'à l'initialisation avec le débitmètre 50 ou le jaugeur 35 par exemple. Le contrôleur 60 reçoit un signal, provenant du débitmètre 50 ou du jaugeur 35, et peut en déduire à chaque instant le volume de carburant consommé depuis le démarrage des moteurs 10.

Dès lors, le régulateur 30, voire le contrôleur 60 réalise une estimation ESTCARBU2 de la masse de carburant en fonction de la masse ou du volume avant vol de carburant ainsi que du volume de carburant consommé, voire d'une masse volumique du carburant. A titre d'exemple, le contrôleur 60 effectue la différence arithmétique du volume avant vol de carburant et du volume de carburant consommé et multiplie cette différence par la masse volumique du carburant.

Selon la troisième alternative de la figure 5, la masse de carburant est paramétrée lors d'une étape de paramétrage STPC3 avec l'interface 51 homme-machine de paramétrage de carburant. Cette interface 51 homme-machine de paramétrage de carburant transmet au contrôleur un signal porteur directement de la masse de carburant MCARBU. Eventuellement, ce paramétrage STPC3 est effectué avant un démarrage des moteurs 10, la masse de carburant étant figée après ledit démarrage. Alternativement, ce paramétrage STPC3 est effectué en vol à l'initialisation du mode école.

Quelle que soit l'alternative, le contrôleur 60 détermine durant la phase d'initialisation la masse initiale MINIT à l'aide de la masse à vide MVD, de la masse MPIL d'un équipage présent dans le giravion 1, de la masse de carburant MCARBU. Le contrôleur 60 peut calculer la masse initiale MINIT en fonction de ces entrées, cette masse initiale MINIT représentant la masse courante estimée du giravion 1. La masse initiale MINIT peut être égale à la somme de la masse à vide MVD, de la masse MPIL d'un équipage présent dans le giravion 1 et de la masse de carburant MCARBU.

Indépendamment de la manière de déterminer la masse initiale MINIT, le mode école comporte une détermination STPMAX en vol de la masse maximale en fonction de conditions extérieures voire aussi du type d'entraînement.

Ainsi, une initialisation du mode école peut comporter une estimation STPEXT de la pression extérieure P0 et de la température extérieure T0. Le senseur de pression extérieure 41 transmet un signal de pression au contrôleur 60, le contrôleur 60 décodant le signal de pression et mémorisant la pression extérieure P0. De même, le senseur de température extérieure 42 transmet un signal de température au contrôleur 60, le contrôleur 60 décodant le signal de température et mémorisant la température extérieure T0

Eventuellement, le procédé comporte une sélection SELECTTYP d'un type d'entraînement avec l'interface 52 homme-machine de sélection à tout moment avant le calcul de la masse maximale. Un équipage sollicite l'interface 52 homme-machine de sélection qui transmet un signal de type d'entraînement au contrôleur 60. Le contrôleur 60 décode le signal de type d'entraînement et mémorise le type d'entraînement.

Dès lors, le régulateur 30, voire le contrôleur 60, applique un modèle mathématique fournissant la masse maximale MMAX en fonction des conditions extérieures voire du type d'entraînement. Un tel modèle peut comprendre une ou plusieurs lois mathématiques, une intelligence artificielle ou autres. Le modèle peut être établi par tests et / ou simulations par exemple.

Indépendamment de la manière de déterminer la masse maximale MMAX et la masse initiale MINIT, le mode école comporte une comparaison STPCOMP avec le régulateur 30, par exemple avec le contrôleur 60, de la masse initiale MINIT avec la masse maximale MMAX. Cette comparaison STPCOMP peut comporter un établissement STPR d'un rapport de proportion RAP entre la masse initiale MINIT et la masse maximale MMAX. Le rapport de proportion RAP peut être égal à la masse initiale MINIT divisée par la masse maximale MMAX.

Dès lors, le mode école comporte une détermination STPAJUST avec le régulateur 30 de chaque butée de régulation OEITRAIN en fonction de cette comparaison, et le cas échéant du rapport de proportion RAP. Cette étape peut être réalisée avec le contrôleur 60 et/ou avec chaque calculateur moteur 80.

Selon la première variante illustrée en traits continus, le régulateur 30, voire le contrôleur 60 ou les calculateurs moteurs 80, sont configurés pour réaliser une estimation STPA1 d'une valeur de régulation de calcul WLIM en fonction dudit rapport de proportion RAP et de la valeur de régulation limite VLIM. La valeur de régulation de calcul WLIM peut être égale au produit du rapport de proportion RAP et de la valeur de régulation limite VLIM. Le régulateur 30 est configuré pour réaliser une détermination STPA2 de chaque butée de régulation OEITRAIN en fonction de la valeur de régulation de calcul WLIM associée et d'un coefficient de répartition COEF propre à chaque butée de régulation OEITRAIN. Ce coefficient de répartition peut être mémorisé. La somme des coefficients de répartition est égale à un.

Selon un exemple chiffré appliqué sur un giravion bimoteur, le rapport de proportion est de 0.8, la masse initiale étant égale à 80 pourcents de la masse maximale. Selon cet exemple, la valeur de régulation limite à laquelle est buté un moteur lors du régime d'urgence appliqué est de 600 Newton-mètres. De plus, la puissance globale durant le mode école est équirépartie ce qui induit un coefficient de réparation égal à 0.5 en présence de deux moteurs 10. Dès lors, le contrôleur 60 ou les calculateurs moteurs 80 en déduisent que la valeur de régulation de calcul WLIM est égale à 0.8 fois 600 soit 480 Newton-mètres, chaque moteur 10 étant finalement buté à un couple moteur de 480 fois 0.5 soit 240 Newton-mètres.

Selon la deuxième variante illustrée en pointillés, le régulateur 30, voire le contrôleur 60 ou les calculateurs moteurs 80, sont configurés pour réaliser une estimation STPA3 pour chaque butée de régulation OEITRAIN d'une valeur intermédiaire VINT en fonction d'un coefficient de répartition COEF propre à chaque butée de régulation OEITRAIN et de la valeur de régulation limite de ces moteurs . Le régulateur 30 est configuré pour réaliser une détermination STPA4 de chaque butée de régulation en fonction de ladite valeur intermédiaire VINT et dudit rapport de proportion RAP.

Selon un exemple chiffré appliqué sur un giravion bimoteur, le rapport de proportion est de 0.8, la masse initiale étant égale à 80 pourcents de la masse maximale. Selon cet exemple, la valeur de régulation limite à laquelle est butée un moteur lors du régime d'urgence appliqué est de 600 Newton-mètres. De plus, la puissance globale durant le mode école est équirépartie ce qui induit un coefficient de réparation égal à 0.5 en présence de deux moteurs. Dès lors, les calculateurs moteurs, par exemple, en déduisent que la valeur intermédiaire VINT est égale à 0.5 fois 600 soit 300 Newton-mètres, chaque moteur 10 étant finalement buté à un couple moteur de 300 fois 0.8 soit 240 Newton-mètres.

Quelle que soit la variante, le mode école comporte alors une régulation STPREG avec le régulateur 30 de chaque moteur 10 de manière usuelle, le paramètre de régulation de chaque moteur 10 étant piloté pour ne pas dépasser la butée de régulation OEITRAIN respective.

Eventuellement, le mode école peut comporter une mesure STPNR d'une vitesse de rotation NR de la voilure tournante 6 avec le senseur 66 de vitesse de rotation. Le contrôleur 60 reçoit le signal de vitesse de rotation émis par le senseur 60, le décode et en déduit la vitesse de rotation NR courante de la voilure tournante 6.

Si la vitesse de rotation NR est supérieure à un seuil NRS mémorisé, le mode école se poursuit. Eventuellement, le mode école peut être désactivé par un équipage, par exemple à l'aide de l'interface 55 homme-machine d'activation du mode école.

Par contre, si la vitesse de rotation NR devient inférieure au seuil NRS, le régulateur 30 est configuré pour effectuer un désengagement STPEXIT automatique avec le régulateur 30 du mode école. De plus le contrôleur 60 transmet un signal d'alerte à l'alerteur 65, l'alerteur 65 étant configuré pour effectuer une génération STPWARN d'une alerte porteuse du désengagement.

Naturellement, la présente invention est sujette à de nombreuses variations quant à sa mise en oeuvre. Bien que plusieurs modes de réalisation aient été décrits, on comprend bien qu'il n'est pas concevable d'identifier de manière exhaustive tous les modes possibles. Il est bien sûr envisageable de remplacer un moyen décrit par un moyen équivalent, le cadre de la présente invention et des revendications étant défini par les revendications.

## Revendications

1. Procédé de simulation d'une panne moteur sur un giravion (1), le giravion (1) comprenant une installation motrice (2) munie de plusieurs moteurs (10) développant conjointement une puissance globale (WGLOB) pour mettre en mouvement une voilure tournante (6), au moins un moteur (10) fonctionnant en brûlant du carburant, chaque moteur (10) présentant un paramètre de régulation plafonné par un régulateur (30) à une valeur de régulation limite durant au moins un régime d'urgence applicable en cas de panne d'un autre moteur (10), le procédé comprenant un mode école comportant une régulation (STPREG) avec le régulateur (30) de chaque moteur (10) afin de simuler une panne moteur, ladite régulation (STPREG) avec le régulateur (30) de chaque moteur (10) comprenant un plafonnement du paramètre de régulation de chaque moteur à une butée de régulation (OEITRAIN) respective,
**caractérisé en ce que** ledit mode école comporte les étapes suivantes :
- détermination (STPM) avec le régulateur (30) d'une masse initiale (MINIT) dudit giravion (1) au moins en fonction d'une masse à vide (MVD) du giravion (1), d'une masse (MPIL) d'un équipage présent dans le giravion (1) paramétrée, d'une masse de carburant (MCARBU) embarqué estimée,
- détermination (STPMAX) en vol avec le régulateur d'une masse maximale pour le giravion établie en fonction au moins de conditions extérieures (P0, T0)
- comparaison (STPCOMP) en vol avec le régulateur (30) de la masse initiale (MINIT) à la masse maximale (MMAX) ,
- détermination (STPAJUST) avec le régulateur (30) de chaque butée de régulation (OEITRAIN) en fonction de ladite comparaison et de ladite valeur de régulation limite.

2. Procédé selon la revendication 1,
**caractérisé en ce que** les conditions extérieures comportent une pression extérieure (P0) et une température extérieure (T0) de l'air présent autour du giravion (1), ledit mode école comportant une estimation (STPEXT) de la pression extérieure (P0) avec un senseur de pression extérieure (41) du régulateur (30) et de la température extérieure (T0) avec un senseur de température extérieure (42) du régulateur (30).

3. Procédé selon l'une quelconque des revendications 1 à 2,
**caractérisé en ce que** le mode école comporte une mesure (MESCARBU) d'une quantité courante de carburant dans le giravion (1) avec un jaugeur (35) du régulateur (30) , et une estimation (ESTCARBU1) de ladite masse de carburant en fonction de ladite quantité courante de carburant à une initialisation du mode école, la quantité courante étant une masse courante ou un volume courant.

4. Procédé selon l'une quelconque des revendications 1 à 2,
**caractérisé en ce que** ledit mode école comporte un paramétrage (STPC1) d'une quantité avant vol de carburant avec une interface (51) homme-machine de paramétrage de carburant du régulateur (30), le mode école comportant : i) une estimation (STPC2) d'une quantité de carburant consommée jusqu'à une initialisation (INI) du mode école, et ii) une estimation (ESTCARBU2) de ladite masse de carburant en fonction de la quantité avant vol de carburant ainsi que de la quantité de carburant consommée.

5. Procédé selon la revendication 4,
**caractérisé en ce que** le procédé comporte un paramétrage (STPC1) avant un démarrage des moteurs (10) de la quantité avant vol avec une interface (51) homme-machine de paramétrage de carburant du régulateur (30), la quantité avant vol étant figée après ledit démarrage.

6. Procédé selon l'une quelconque des revendications 1 à 2,
**caractérisé en ce que** ladite masse de carburant est paramétrée avec une interface (51) homme-machine de paramétrage de carburant du régulateur (30).

7. Procédé selon la revendication 6,
**caractérisé en ce que** le procédé comporte un paramétrage (STPC3) avant un démarrage des moteurs (10) de la masse de carburant, la masse de carburant étant figée après ledit démarrage.

8. Procédé selon l'une quelconque des revendications 1 à 7,
**caractérisé en ce que** le procédé comporte une sélection (SELECTTYP) d'un type d'entraînement avec une interface (52) homme-machine de sélection du régulateur, la détermination (STPMAX) en vol avec le régulateur de la masse maximale étant fonction du type d'entraînement sélectionné avec l'interface (52) homme-machine de sélection.

9. Procédé selon la revendication 8,
**caractérisé en ce que** ledit type d'entraînement est choisi dans une liste comprenant : un entraînement de catégorie A requérant la possibilité de poursuivre le vol après la panne moteur et un entraînement de catégorie B requérant la possibilité d'atterrir en sécurité après la panne moteur.

10. Procédé selon l'une quelconque des revendications 1 à 9,
**caractérisé en ce que** ladite paramètre de régulation est un couple moteur ou une puissance.

11. Procédé selon l'une quelconque des revendications 1 à 10,
**caractérisé en ce que** ladite comparaison (STPCOMP) avec le régulateur (30) de la masse initiale (MINIT) à la masse maximale (MMAX) comporte un établissement (STPR) d'un rapport de proportion (RAP) entre la masse initiale (MINIT) et la masse maximale (MMAX)

12. Procédé selon la revendication 11,
**caractérisé en ce que** ladite détermination (STPAJUST) avec le régulateur (30) de chaque butée de régulation (OEITRAIN) en fonction de ladite comparaison comprend pour chaque moteur : i) une estimation (STPA1) d'une valeur de régulation de calcul (WLIM) en fonction dudit rapport de proportion (RAP) et de la valeur de régulation limite, puis ii) une détermination (STPA2) de la butée de régulation (OEITRAIN) en fonction de ladite valeur de régulation de calcul (WLIM) et d'un coefficient de répartition (COEF) propre à chaque butée de régulation (OEITRAIN).

13. Procédé selon la revendication 11,
**caractérisé en ce que** ladite détermination (STPAJUST) avec le régulateur (30) de chaque butée de régulation (OEITRAIN) en fonction de ladite comparaison comprend pour chaque moteur : i) une estimation (STPA3) d'une valeur intermédiaire (VINT) en fonction d'un coefficient de répartition (COEF) propre à chaque butée de régulation (OEITRAIN) et de la valeur de régulation limite, puis ii) une détermination (STPA4) de chaque butée de régulation en fonction de ladite valeur intermédiaire (VINT) et dudit rapport de proportion (RAP).

14. Procédé selon l'une quelconque des revendications 1 à 13,
**caractérisé en ce que** le procédé comporte un paramétrage (STPMVD) avant un démarrage des moteurs de la masse à vide (MVD) avec une interface (53) homme-machine de masse à vide du régulateur (30), et un paramétrage (STPMPIL) avant un démarrage des moteurs de la masse (MPIL) d'un équipage présent dans le giravion (1) avec une interface (54) homme-machine de masse équipage du régulateur (30), la masse à vide (MVD) et la masse (MPIL) d'un équipage présent dans le giravion (1) étant figées après ledit démarrage.

15. Procédé selon l'une quelconque des revendications 1 à 14,
**caractérisé en ce que** le procédé comporte une mesure (STPNR) d'une vitesse de rotation (NR) de la voilure tournante (6) avec un senseur de vitesse de rotation (NR) du régulateur (30), un désengagement (STPEXIT) automatique avec le régulateur (30) du mode école dès que la vitesse de rotation (NR) est inférieure à un seuil (NRS) mémorisé, et une génération (STPWARN) d'une alerte porteuse du désengagement.

16. Giravion (1) muni comprenant une installation motrice (2) munie de plusieurs moteurs (10) développant conjointement une puissance globale (WGLOB) pour mettre en mouvement une voilure tournante (6), chaque moteur (10) développant une puissance plafonnée par un régulateur (30) à une valeur de puissance limite lors de l'application d'au moins un régime d'urgence en cas de panne d'au moins un autre moteur,
**caractérisé en ce que** le régulateur (30) est configuré pour appliquer le procédé selon l'une quelconque des revendications 1 à 15.
